# EUROPÄISCHE PATENTSCHRIFT

(11) **EP 1 834 353 B1**
(45) Veröffentlichungstag und Bekanntmachung des Hinweises auf die Patenterteilung: **15.08.2012**
(21) Anmeldenummer: 05810903.4
(22) Anmeldetag: 07.11.2005
(51) Int. Cl.: H01L 21/78, H01L 29/04, H01L 29/66, H01L 29/866

(54) **VERFAHREN ZUM HERSTELLEN VON HALBLEITERCHIPS AUS EINEM WAFER**
METHOD FOR PRODUCING SEMICONDUCTOR CHIPS FROM A WAFER
PROCEDE DE FABRICATION DE PUCES A SEMICONDUCTEURS A PARTIR D'UNE PLAQUETTE

(30) Priorität: 29.12.2004 DE 102004063180
(43) Veröffentlichungstag der Anmeldung: 19.09.2007
(73) Patentinhaber: ROBERT BOSCH GMBH, 70442 Stuttgart (DE)
(72) Erfinder: SPITZ, Richard, 72766 Reutlingen (DE); GOERLACH, Alfred, 72127 Kusterdingen (DE); HAHN, Friederike, 72770 Reutlingen (DE)
(86) Internationale Anmeldenummer: PCT/EP2005/055790
(87) Internationale Veröffentlichungsnummer: WO 2006/072493

(56) Entgegenhaltungen:
- WO-A-03/061015
- DE-A1- 2 633 324
- DE-A1- 2 730 130
- DE-A1- 4 320 780
- US-A- 3 387 192
- PATENT ABSTRACTS OF JAPAN Bd. 009, Nr. 185 (E-332), 31. Juli 1985 (1985-07-31) -& JP 60 055640 A (SANYO DENKI KK; others: 01), 30. März 1985 (1985-03-30)
- LI Z ET AL: "ELECTRICAL AND TRANSIENT CURRENT CHARACTERIZATION OF EDGELESS SI DETECTORS DICED WITH DIFFERENT METHODS" IEEE TRANSACTIONS ON NUCLEAR SCIENCE, IEEE SERVICE CENTER, NEW YORK, NY, US, Bd. 49, Nr. 3, Juni 2002 (2002-06), Seiten 1040-1046, XP011077622 ISSN: 0018-9499

## Beschreibung

Die Erfindung betrifft ein Verfahren zum Herstellen von Halbleiterchips aus einem Wafer gemäß dem Oberbegriff des Patentanspruchs 1.

Halbleiterbauelemente, wie z.B. Dioden, Transistoren oder Thyristoren umfassen üblicherweise einen in einem Gehäuse verpackten Halbleiterchip. Die Halbleiterchips werden in der Regel aus einem Wafer hergestellt, der üblicherweise sehr viele gleiche Halbleiterchips umfasst. Nach der Fertigstellung des Wafers, i.d.R. nach einem letzten Metallisierungsschritt, werden die Chips aus dem Wafer herausgetrennt. Das Vereinzeln der Chips erfolgt i.d.R. mittels einer Diamantsäge. Dieser Sägeprozess ist relativ einfach zu realisieren, hat jedoch den Nachteil, dass entlang der Schnittflächen Kristallstörungen am gesamten Chiprand erzeugt werden, die sich bis zu einer Tiefe von einigen 10 Mikrometern in den Chip hinein erstrecken. Diese Kristallstörungen sind insbesondere bei Bauelementen kritisch, die einen am Chiprand befindlichen pn-Übergang aufweisen. In diesem Fall endet der pn-Übergang im Bereich der gestörten Kristallzone und wird dort gestört. Bei Z-Dioden kann dadurch z. B. eine deutliche Erhöhung der Sperrströme beobachtet werden.

Es ist bekannt, die gestörten Kristallbereiche z.B. durch Ätzen der seitlichen Chipränder zu entfernen und damit auch die Sperrströme zu reduzieren. Dies erfordert aber einen zusätzlichen aufwendigen und kostspieligen Prozessschritt.

Aus der DE-27 30 130 A1 sind Verfahren zum Herstellen von Halbleiterchips bekannt, bei denen auf einem Wafer Sollbruchstellen auf der Vorder- und Rückseite erzeugt werden. Entlang dieser Sollbruchstellen wird der Wafer in die einzelnen Chips gebrochen. Die Sollbruchstellen sind linienförmig und liegen in der Mitte von Gräben. Durch diese Maßnahme wird sicher gestellt, dass keine Kristallstörungen an der Bruchkante auftreten, wodurch sich ein Ätzen der Bruchkanten erübrigt.

Aus der DE- 43 20 780 A1 sind Verfahren zum Herstellen von Halbleiterchips bekannt, bei denen die Chips so ausgestaltet sind, dass der pn-Übergang bis zum Rand des Chips reicht, jedoch am Rand eine geringere Dotierung aufweist als in der Mitte, so dass der Hauptübergang in der Mitte stattfindet. Die Vereinzelung der Chips findet durch Brechen in den Gräben statt. Dies führt zu keinen Problemen an den Bruchkanten, da am Rand der Chips nur eine geringe Dotierung herrscht.

Es ist die Aufgabe der vorliegenden Erfindung, ein Verfahren zum Vereinzeln von Halbleiterchips, insbesondere Z-Dioden, aus einem Wafer zu schaffen, das weniger Kristallstörungen im Bereich des pn-Übergangs der Chips verursacht.

Gelöst wird diese Aufgabe gemäß der Erfindung durch die im Patentanspruch 1 angegebenen Merkmale. Weitere Ausgestaltungen der Erfindung sind Gegenstand von Unteransprüchen.

Ein wesentlicher Gedanke der Erfindung besteht darin, nach der Fertigstellung des Wafers (i.d.R. nach einem letzten Metallisierungsprozess) Sollbruchstellen in der Waferoberfläche zu erzeugen, in Form von linienförmigen Vertiefungen, und den Wafer entlang der Sollbruchstellen zu brechen, um die Halbleiterchips zu vereinzeln. Das Brechen des Wafers hat den wesentlichen Vorteil, dass an den Seitenflächen der Chips im Vergleich zum Sägen weniger Kristallstörungen entstehen. Insbesondere im Falle von Z- oder Zenerdioden kann somit der Sperrstrom reduziert werden.

Darüber hinaus ist es nicht unbedingt erforderlich, die Seitenflächen der Chips nach dem Vereinzeln nachzubearbeiten, um Kristallstörungen zu entfernen, wodurch ein zusätzlicher Prozessschritt eingespart werden kann. Grundsätzlich ist es natürlich weiterhin möglich die Chipkanten nach dem Brechen zu überätzen, um die Sperrströme in gewissen Fällen noch weiter zu reduzieren. Dabei wird aber vorzugsweise ein wesentlich geringerer Ätzabtrag von vorzugsweise weniger als 10 µm gewählt, da sich der gestörte Kristallbereich nicht mehr in eine große Tiefe erstreckt (Flashätzen). Als Ätzverfahren können alle in der Halbleitertechnik verwendeten Ätzverfahren Verwendung finden. Der Ätzprozess kann auch zu einem späteren Zeitpunkt, z. B. nach einer Lötmontage, erfolgen.

Das erfindungsgemäße Verfahren zum Vereinzeln von Halbleiterchips ist insbesondere für solche Bauelemente anwendbar, deren Halbleiterchips einen bis zum seitlichen Rand des Chips reichenden pn-Übergang aufweisen, und insbesondere einen solchen pn-Übergang, der im Randbereich des Chips eine kleinere Differenz der Ladungsdichte hat als in der Mitte des Chips. Die Raumladungszone dehnt sich dadurch am Rand weiter aus als in der Chipmitte, so dass auch die elektrische Feldstärke im Randbereich herabgesetzt ist. Diese spezielle Auslegung des pn-Übergangs hat den Vorteil, dass das Bauelement relativ unempfindlich gegen Kristallstörungen am seitlichen Rand des Chips ist. Die seitlichen Bruchkanten der Halbleiterchips müssen daher nicht mehr z.B. durch Ätzen nachbearbeitet werden, um die Kristallstörungen zu entfernen.

Geeignete Bauelemente, bei denen der pn-Übergang im Randbereich des Chips endet, sind z.B. Dioden, Z-Dioden, Zenerdioden, Transistoren, Thyristoren, etc./ Geeignete Bauelemente mit einem pn-Übergang mit reduzierter Randfeldstärke sind insbesondere ZR-Dioden.

Die Sollbruchstellen werden vorzugsweise durch Sägen, z.B. mittels einer Diamantsäge, erzeugt. Wahlweise könnten die Sollbruchstellen z.B. auch mittels Laser oder photolithographischen Verfahren mit anschließender Nass- oder Trockenätzung erzeugt werden.

Bei der Herstellung der Sollbruchstellen in der Waferoberfläche ist erfindungsgemäßβ darauf zu achten, dass die Tiefe der Sollbruchstellen geringer ist als die Tiefe des pn-Übergangs im Randbereich des Chips. D.h., die Sollbruchstelle sollte nicht über den pn-Übergang hinausgehen. Dies gilt insbesondere für die Herstellung von Sollbruchstellen durch Ansägen der Waferoberfläche, da andernfalls die Kristallstruktur im Bereich des pn-Übergangs wiederum geschädigt werden würde.

Die Sollbruchstellen können entweder an der Vorderseite, der Rückseite oder in Vorder- und Rückseite des Wafers erzeugt werden.

Die Orientierung der Sollbruchstellen bezüglich der Kristallstruktur des Wafers wird vorzugsweise derart gewählt, dass sie parallel zu Kristallflächen verlaufen, die sich leicht brechen lassen. Eine andere Orientierung kann ebenfalls gewählt werden, ist jedoch weniger günstig.

Im Fall eines (100)-orientierten Siliziumwafers verlaufen die Sollbruchstellen vorzugsweise parallel bzw. senkrecht zu einem (100)-Orientierungsflat, wobei rechteckige Chips erzeugt werden. Bei Verwendung eines (111)-orientierten Siliziumwafers können auch sechseckige Halbleiterchips hergestellt werden. Die Sollbruchstellen verlaufen in diesem Fall unter einem Winkel von 30° und 90° bezogen auf einen (110)-Kennzeichnungsflat. Die Brechkanten der einzelnen Chips laufen in diesem Fall wiederum in Richtung leicht brechender (111)-Kristallflächen.

Gemäß einer bevorzugten Ausführungsform der Erfindung wird der Wafer vor dem Vereinzeln der Chips auf eine Folie, vorzugsweise eine selbstklebende Folie, aufgebracht und in diesem Zustand gebrochen. Nach dem Brechen kann die Folie ausgedehnt und die einzelnen Chips direkt von der Folie zur weiteren Verarbeitung, wie z.B. zum Löten oder zur Verpackung, abgepickt werden.

Der Wafer wird in diesem Fall vorzugsweise in Richtung zur Folie hin gebrochen. Dadurch wird verhindert, dass die Chips beim Brechen aneinander reiben und beschädigt werden.

Die Erfindung wird nachstehend anhand der beigefügten Zeichnungen beispielhaft näher erläutert. Es zeigen:
Fig. 1 eine Seitenansicht auf einen aus dem Stand der Technik bekannten Chip einer Z-Diode mit reduzierter Randfeldstärke;
Fig. 2 eine Seitenansicht des Chips einer Z-Diode mit reduzierter Randfeldstärke gemäß einer Ausführungsform der Erfindung.
Fig. 3a, 3b verschiedene Wafer mit unterschiedlicher Kristallorientierung; und
Fig. 4a-4c verschiedene Ausführungsformen von Diamantsägen zum Sägen der Waferoberfläche.

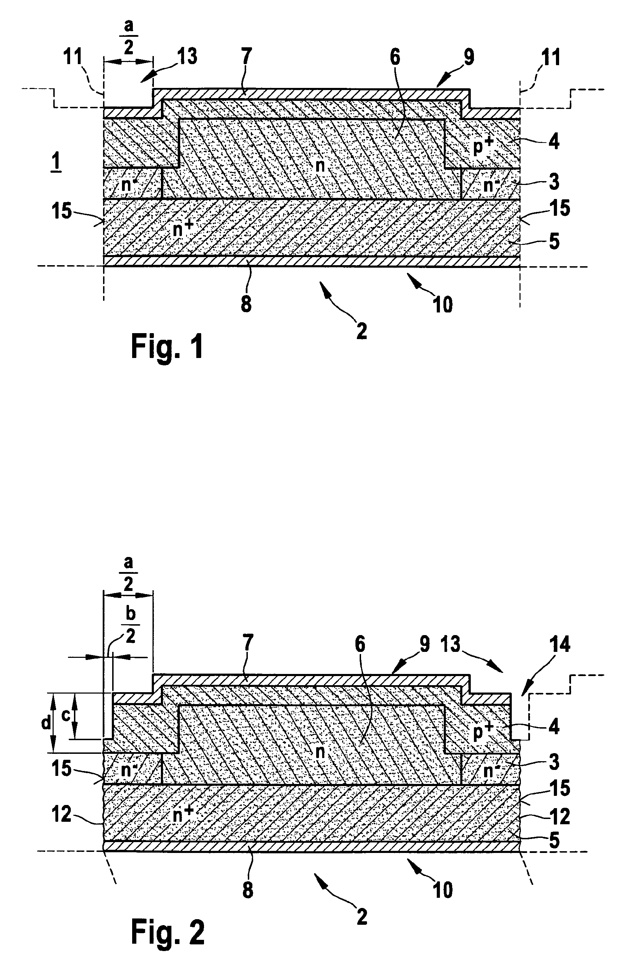

Fig. 1 zeigt den Halbleiterchip 2 einer aus dem Stand der Technik bekannten Z-Diode mit reduzierter Randfeldstärke, die auch als ZR-Diode bezeichnet wird. Der Diodenchip 2 ist aus einem Siliziumsubstrat gefertigt, das z.B. eine n-Dotierung von ca. 8x10¹⁵ cm⁻³ aufweist. Der Chip 2 umfasst von der Vorderseite 9 zur Rückseite 10 betrachtet eine p⁺-dotierte Schicht 4, eine darunter liegende n-dotierte Substratschicht 6, die seitlich von der p⁺-Schicht 4 und einer darunter liegenden schwach n⁻-dotierten Schicht 3 umgeben ist, sowie eine an der Rückseite 10 des Chips angeordnete stark n⁺-dotierte Schicht 5. Auf der Vorderseite 9 und Rückseite 10 sind ferner Metallisierungsschichten 7 bzw. 8 aufgebracht.

Die ZR-Diode zeichnet sich dadurch aus, dass der Durchbruch bei einem Betrieb in Sperrichtung nur in der Chipmitte und nicht im Randbereich des Diodenchips 2 erfolgt. Dieser Effekt beruht darauf, dass die Z-Diode in der Mitte und am Rand 15 des Diodenchips 2 unterschiedliche pn-Übergänge aufweist. Im mittleren Bereich des Diodenchips wird der pn-Übergang durch die Schichten 4-6 und im Randbereich durch die Schichten 4-3 gebildet, wobei die Differenz der Ladungsdichte im mittleren Bereich wesentlich höher ist als im Randbereich. Damit ist auch die Durchbruchspannung des mittleren pn-Übergangs 4-6 kleiner als die Durchbruchspannung des pn-Übergangs 4-3. Somit ist sichergestellt, dass der Avalanche-Durchbruch nur in der Chipmitte und nicht am Rand erfolgt. Bei Betrieb in Sperrichtung dehnt sich die Raumladungszone am Rand des Chips 2 außerdem weiter aus als in der Chipmitte, so dass die elektrische Feldstärke im Randbereich geringer ist als in der Mitte. Daher wird die Z-Diode auch als ZR-Diode (mit reduzierter Randfeldstärke) bezeichnet.

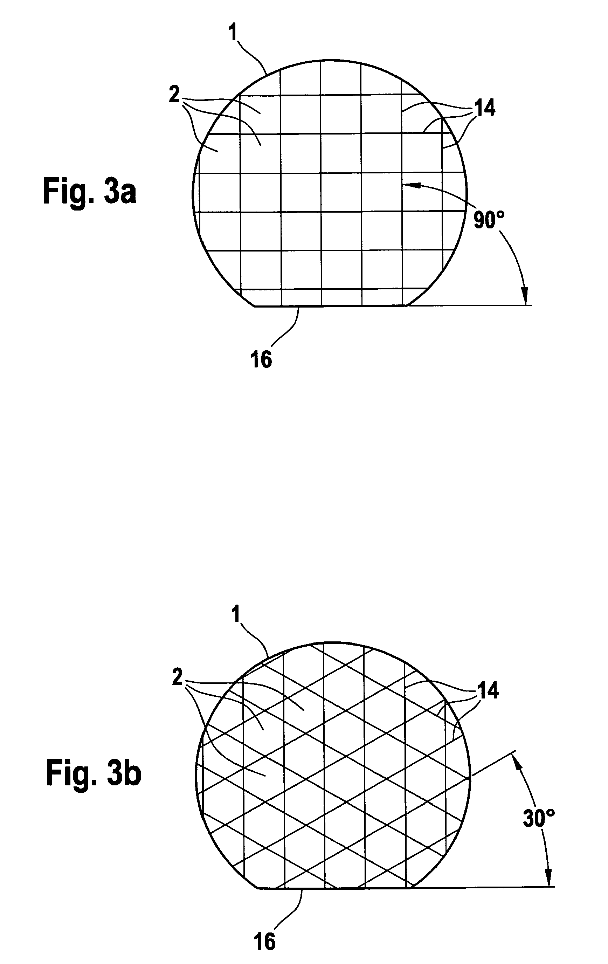

Die Diodenchips 2 werden aus einem Wafer 1, wie z.B. einem Siliziumwafer hergestellt, wie er in den Fig. 3a und 3b gezeigt ist. Gemäß dem Stand der Technik werden die Waferscheiben nach der Fertigstellung des Wafers 1 entlang der Ränder 15 der Chips 2 zersägt, um diese zu vereinzeln. Die Schnittkanten sind in Fig. 1 mit dem Bezugszeichen 11 bezeichnet. Das Sägen des Wafers 1 hat jedoch den Nachteil, dass entlang der Schnittflächen Kristallstörungen am gesamten Chiprand erzeugt werden, die die Funktion des Bauelements beeinträchtigen können.

Fig. 2 zeigt einen Diodenchip 2 einer Z-Diode, der in Bezug auf das Dotierprofil mit demjenigen von Fig. 1 identisch ist. Im Unterschied zum Diodenchip 2 von Fig. 1 weist dieser jedoch Sollbruchstellen 14 (hier als Vertiefung dargestellt) auf, an denen der Wafer 1 gebrochen wurde. Die seitlichen Bruchkanten sind mit dem Bezugszeichen 12 bezeichnet. Das Brechen des Wafers 1 hat den Vorteil, dass im Vergleich zum Sägen wesentlich geringere Kristallstörungen im Bereich des pn-Übergangs 4-3 erzeugt werden und somit der Sperrstrom der Z-Diode reduziert werden kann.

Die Seitenkanten 15 sind hier vereinfacht unter einem rechten Winkel zur Vorder- 9 bzw. Rückseite 10 eingezeichnet. Dies ist nicht für alle Kristallorientierungen richtig, da die brechenden Kristallflächen nicht unbedingt senkrecht, sondern oft auch leicht schräg verlaufen. Bei der Erzeugung von Sollbruchstellen 14 sowohl an der Vorder- 9 als auch an der Rückseite 10 ist dies zu berücksichtigen.

Die Darstellung einer ZR-Diode ist hier nur beispielhaft gewählt. Wahlweise ist die Erfindung auch auf andere Bauelemente anwendbar, die einen bis zum seitlichen Rand 15 des Halbleiterchips reichenden pn-Übergang aufweisen, wie z.B. andere Dioden, Transistoren, Thyristoren, etc., und insbesondere solche Bauelemente, bei denen der Stromfluss im Randbereich geringer ist als in der Chipmitte.

Bei der Herstellung der Chips werden in einem ersten Verfahrensschritt Sollbruchstellen 14 in der Waferoberfläche erzeugt und der Wafer danach entlang dieser Sollbruchstellen 14 gebrochen, um die Chips 2 zu vereinzeln. Die Sollbruchstellen 14 sind hier als linienförmige Vertiefungen dargestellt, können aber auch eine andere Form haben oder z.B. perforationsartig gebildet sein. Solche andere Formen sind aber kein Teil der Erfindung.

Die Sollbruchstellen 14 werden vorzugsweise mittels einer Diamantsäge hergestellt, können aber auch mittels Laserschneiden oder durch photolithographische Verfahren mit anschließendem Ätzen erzeugt werden. Erfindungsgemäßβ, und insbesondere beim Sägen der Sollbruchstellen 14 ist darauf zu achten, dass die Tiefe c des Sägeschlitzes kleiner ist als die Tiefe d des pn-Übergangs 4-3 im Randbereich des Halbleiterchips 2, da andernfalls die Kristallstruktur im Bereich des pn-Übergangs 4-3 wiederum gestört werden würde.

Die Breite b des Sägeblatts kann z.B. zwischen 100 µm und 300 µm und die Sägetiefe c z.B. zwischen 2µm und 60 µm betragen. Nach dem Herstellen der Sollbruchstellen 14 erfolgt das Vereinzeln der Chips 2 durch Brechen des Wafers 1. Dabei wird z.B. mittels einer Walze eine flächige Kraft auf die Oberfläche des Wafers 1 ausgeübt.

Die Sollbruchstellen sind hier nur in der Vorderseite 9 des Chips dargestellt, können aber auch auf der Rückseite 10 oder auf beiden Seiten vorgesehen sein.

Die Sollbruchstellen 14 erstrecken sich vorzugsweise parallel zu solchen Kristallflächen, die sich leicht brechen lassen. Dies sind im Falle eines Siliziumwafers insbesondere die (111)-Ebenen.

Fig. 3a und 3b zeigen zwei Siliziumwafer 1 mit unterschiedlicher Kristallorientierung, wobei der Wafer 1 von Fig. 3a eine (100)-Orientierung und der Wafer 1 von Fig. 3b eine (111)-Orientierung aufweist. In Fig. 3a verlaufen die linienförmigen Sägeschlitze 14 senkrecht und parallel zu einem (110)-Orientierungsflat 16, wodurch rechteckige Chips 2 entstehen. In Fig. 3b verlaufen die Sägeschlitze 14 unter einem Winkel von 30° sowie senkrecht zum (110)-Orientierungsflat 16. Dadurch entstehen sechseckige Chips 2 mit leicht brechenden (111)-Kristallflächen.

Grundsätzlich ist es nicht unbedingt erforderlich, die Sollbruchstellen immer parallel zu den leicht zu spaltenden (111)-Kristallflächen zu legen. So kann z.B. auch der (111)-orientierte Wafer 1 von Fig. 3b in Quadrate entsprechend Fig. 3a aufgeteilt werden. In diesem Fall werden vorzugsweise zuerst die schwerer zu brechenden (110)-Kanten parallel zum Orientierungsflat 16 und danach die dazu senkrecht stehenden (111)-Kanten gebrochen.

Die Sägeschlitze 14 können z.B. mittels einer Diamantsäge erzeugt werden, die z.B. aus in Nickel eingebrachten Diamantsplittern besteht. Es können aber auch speziell geformte Diamantsägeblätter verwendet werden, die spitz zulaufen oder eine andere Form aufweisen, die von der herkömmlichen Rechteckform abweicht.

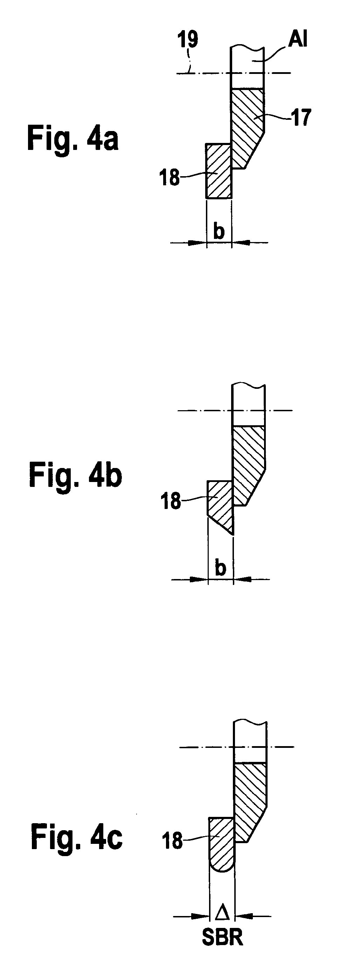

Fig. 4a bis 4c zeigen verschiedene Ausführungsformen von Diamantsägeblättern mit einem Träger 17, an dem eine Schneidfläche 18 angebracht ist. Das Sägeblatt ist rotationssymmetrisch gebildet und dreht sich um eine Rotationsachse 19.

Fig. 4a zeigt ein Sägeblatt mit einer rechteckigen Diamant-Schneidfläche. Die Breite der Schneidfläche ist mit b bezeichnet. Fig. 4b zeigt ein Diamant-Sägeblatt mit einer nach außen spitz zulaufenden Schneidfläche 18 und 4c ein Diamant-Sägeblatt mit einer nach außen konvex zulaufenden Schneidfläche. Die Schneidflächen 18 der Fig. 4b und 4c haben den Vorteil, dass sie im Vergleich zur Ausführungsform von Fig. 4a weniger Kristallstörungen verursachen.

### Bezugszeichenliste

- 1: Wafer
- 2: Halbleiterchip
- 3: schwach dotiertes n⁻-Gebiet
- 4: stark dotiertes p⁺-Gebiet
- 5: stark dotiertes n⁺-Gebiet
- 6: n-Gebiet
- 7: Metallisierungsschicht
- 8: Metallisierungsschicht
- 9: Vorderseite
- 10: Rückseite
- 11: Schnittkante
- 12: Bruchkante
- 13: Graben
- 14: Sollbruchstelle
- 15: Seitenflächen
- 16: Orientierungsflat
- 17: Träger
- 18: Diamant-Schneidfläche
- 19: Rotationsachse
- a: Breite des Grabens
- b: Breite der Sollbruchstelle 14
- c: Tiefe der Sollbruchstelle
- d: Tiefe des pn-Übergangs 4-3

## Patentansprüche

1. Verfahren zum Herstellen von Halbleiterchips (2), insbesondere ZR-Diodenchips, aus einem Wafer (1), der eine Vielzahl von Halbleiterchips (2) umfasst, wobei in der Waferoberfläche Sollbruchstellen (14) erzeugt werden und der Wafer (1) entlang der Sollbruchstellen (14) gebrochen wird, um die Halbleiterchips (2) zu vereinzeln, wobei die Sollbruchstellen (14) als linienförmige Vertiefungen realisiert sind und diese Sollbruchstellen (14) in der Mitte des Grabes (13) liegen, **dadurch gekennzeichnet, dass** das Verfahren für Halbleiterchips (2) mit einem pn-Übergang (4-3) verwendet wird, der bis zum seitlichen Rand (15) der Halbleiterchips (2) heranreicht und dass die Tiefe (c) der Sollbruchstellen (14) geringer ist als die Tiefe (d) eines im seitlichen Randbereich der Halbleiterchips (2) befindlichen pn-Übergangs (4-3).

2. Verfahren nach Anspruch 1, **dadurch gekennzeichnet, dass** die Sollbruchstellen (14) in die Waferoberfläche gesägt werden.

3. Verfahren nach einem der vorhergehenden Ansprüche, **dadurch gekennzeichnet, dass** die Sollbruchstellen (14) in der Vorderseite (9) des Wafers (1) erzeugt werden.

4. Verfahren nach einem der Ansprüche 1 bis 3, **dadurch gekennzeichnet, dass** die Sollbruchstellen (14) in der Vorder- (9) und Rückseite (10) erzeugt werden.

5. Verfahren nach einem der vorhergehenden Ansprüche, **dadurch gekennzeichnet, dass** die Orientierung der Sollbruchstellen (14) bezüglich der Kristallstruktur des Wafers (1) derart gewählt wird, dass sie parallel zu Kristallflächen verlaufen, die sich leicht brechen lassen.

6. Verfahren nach einem der vorhergehenden Ansprüche, **dadurch gekennzeichnet, dass** der mit den Sollbruchstellen versehene Wafer (1) vor dem Vereinzeln der Chips (2) auf eine Folie aufgeklebt wird.

## Claims

1. Method for producing semiconductor chips (2), more particularly ZR diode chips, from a wafer (1) comprising a multiplicity of semiconductor chips (2), wherein desired breaking locations (14) are produced in the wafer surface and the wafer (1) is broken along the desired breaking locations (14) in order to singulate the semiconductor chips (2) wherein the desired breaking locations (14) are realized as linear depressions and said desired breaking locations (14) lie in the centre of the trench (13), **characterized in that** the method is used for semiconductor chips (2) having a pn junction (4-3) extending as far as the lateral edge (15) of the semiconductor chips (2), and **in that** the depth (c) of the desired breaking locations (14) is less than the depth (d) of a pn junction (4-3) situated in the lateral edge region of the semiconductor chips (2).

2. Method according to Claim 1, **characterized in that** the desired breaking locations (14) are sawn into the wafer surface.

3. Method according to either of the preceding claims, **characterized in that** the desired breaking locations (14) are produced in the front side (9) of the wafer (1).

4. Method according to any of Claims 1 to 3, **characterized in that** the desired breaking locations (14) are produced in the front side (9) and rear side (10).

5. Method according to any of the preceding claims, **characterized in that** the orientation of the desired breaking locations (14) with respect to the crystal structure of the wafer (1) is chosen in such a way that they run parallel to crystal surfaces which can easily be broken.

6. Method according to any of the preceding claims, **characterized in that** the wafer (1) provided with the desired breaking locations is adhesively bonded onto a film before the chips (2) are singulated.

## Revendications

1. Procédé de fabrication de puces semi-conductrices (2), en particulier de puces de diode ZR, à partir d'une galette (1) qui comporte plusieurs puces semi-conductrices (2),
des emplacements (14) de rupture préférentielle étant formés dans la surface de la galette et la galette (1) étant rompue le long des emplacements (14) de rupture préférentielle pour séparer les puces semi-conductrices (2),
les emplacements (14) de rupture préférentielle étant réalisés sous la forme de creux de forme linéaire et ces emplacements (14) de rupture préférentielle étant situés au milieu du sillon (13),
**caractérisé en ce que**
le procédé est utilisé pour des puces semi-conductrices (2) dont la transition pn (4-3) s'étend jusqu'à la bordure latérale (15) de la bordure semi-conductrice (2) et
**en ce que** la profondeur (c) des emplacements (14) de rupture préférentielle est inférieure à la profondeur (d) de la transition pn (4-3) située dans la bordure latérale de la puce semi-conductrice (2).

2. Procédé selon la revendication 1, **caractérisé en ce que** les emplacements (14) de rupture préférentielle sont sciés dans la surface de la galette.

3. Procédé selon l'une des revendications précédentes, **caractérisé en ce que** les emplacements (14) de rupture préférentielle sont formés dans le côté avant (9) de la galette (1).

4. Procédé selon l'une des revendications 1 à 3, **caractérisé en ce que** les emplacements (14) de rupture préférentielle sont formés dans le côté avant (9) et dans le côté arrière (10).

5. Procédé selon l'une des revendications précédentes, **caractérisé en ce que** l'orientation des emplacements (14) de rupture préférentielle par rapport à la structure cristalline de la galette (1) est sélectionnée de telle sorte qu'ils s'étendent parallèlement aux surfaces du cristal qui se laissent rompre aisément.

6. Procédé selon l'une des revendications précédentes, **caractérisé en ce que** la galette (1) dotée des emplacements de rupture préférentielle est collée sur un film avant la découpe des puces (2).
